(19) Europäisches Patentamt
European Patent Office
Office européen des brevets

(11) Publication number: **0 365 692 B1**

# (12) EUROPEAN PATENT SPECIFICATION

(45) Date of publication of patent specification: **30.11.94**

(51) Int. Cl.5: **B29C 55/12**, C23C 14/24

(21) Application number: **89905212.0**

(22) Date of filing: **20.04.89**

(86) International application number:
**PCT/JP89/00426**

(87) International publication number:
**WO 89/10252 (02.11.89 89/26)**

## (54) POLYPHENYLENE SULFIDE FILM, PROCESS FOR ITS PRODUCTION, AND PROCESS FOR SUBJECTING THE FILM TO VACUUM DEPOSITION.

(30) Priority: **22.04.88 JP 100620/88**
**21.06.88 JP 152588/88**

(43) Date of publication of application:
**02.05.90 Bulletin 90/18**

(45) Publication of the grant of the patent:
**30.11.94 Bulletin 94/48**

(84) Designated Contracting States:
**BE DE FR GB NL**

(56) References cited:
**EP-A- 0 268 489**
**DE-A- 3 212 908**
**FR-A- 1 196 998**
**GB-A- 1 154 571**
**GB-A- 2 168 911**
**US-A- 2 971 862**

**DATABASE WPIL, no. 83-10443k [05], Derwent Publications Ltd, London, GB;& JP-A-57 205 118 (TORAY) 16-12-1982**

(73) Proprietor: **TORAY INDUSTRIES, INC.**
**2-1, Nihonbashi Muromachi 2-chome**
**Chuo-ku**
**Tokyo 103 (JP)**

(72) Inventor: **DEGUCHI, Yukichi**
**B1-23**
**10, Sonoyama 2-chome**
**Otsu-shi Shiga 520 (JP)**
Inventor: **SUZUKI, Motoyuki**
**A1-13**
**16, Takehana Jizo-ji Minamimachi**
**Yamashina-ku Kyoto-shi Kyoto 607 (JP)**
Inventor: **KATSUMATA, Kyuji**
**291, Oiwake-cho**
**Kusatsu-shi Shiga 525 (JP)**

(74) Representative: **Kador & Partner**
**Corneliusstrasse 15**
**D-80469 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

DATABASE WPIL, accession no. 85-059804 [10], Derwent Publications Ltd, London,GB; & JP-A-60 017 073 (DAICEL CHEM.) 28-01-1985

See also references of WO8910252

## Description

### TECHNICAL FIELD

The present invention relates to a biaxially oriented polyphenylene sulfide film with excellent properties suited as a substrate for vacuum vapor-deposition of a metal, a manufacturing process thereof and a method of vacuum vapor-deposition thereon. The polyphenylene sulfide film with a vapor-deposited metal may be used as a capacitor or the like.

### BACKGROUND ART

Biaxially oriented polyphenylene sulfide film is known as a heat resistant film with excellent properties as disclosed in USP4,286,018 and so on. It is also disclosed in Japanese Patent Laid Open Application (Kokai) No. 255978/85 that a metallized film is manufactured by vacuum vapor-depositing aluminum or the like on the polyphenylene sulfide film, and the metallized film is used as a capacitor or the like. Further, it is well-known that a spooling type vacuum vapor deposition apparatus is used for manufacturing the metallized film.

However, when a conventional polyphenylene sulfide film is metallized by using a spooling type vacuum vapor-deposition apparatus, the film is likely to wrinkle on a cooling can of the vapor-deposition apparatus. The wrinkles are fixed by the latent heat of the vaporized metal and the metallized film is wrinkled accordingly, so that the flatness of the metallized film is degraded (this phenomenon is hereinafter referred to as "heat damage"). If a metallized film suffered from the "heat damage" is slit to manufacture tapes for use as a capacitor, the dimensional precision is degraded, so that defects of the capacitor may be brought about by the fact that, for example, the width of the margin region (non-metallized region) is fluctuated. Further, in a extreme case, the film is notched at the wrinkles to break the film.

### DISCLOSURE OF THE INVENTION

Accordingly, the object of the present invention is to overcome the problem encountered when the conventional polyphenylene sulfide film is metallized by vacuum vapor-deposition, and to provide a polyphenylene sulfide film with which the phenomenon ("heat damage") in which the wrinkles in the film are fixed by the latent heat of the vaporization of the metal when a metal is vapor-deposited on the polyphenylene sulfide film by using a spooling type vacuum vapor-deposition apparatus so that the wrinkles are left in the metallized film to degrade the flatness of the same hardly occurs.

Another object of the present invention is to provide a process of manufacturing the above-mentioned polyphenylene sulfide film.

Still another object of the present invention is to provide a method of vacuum vapor-depositing a metal on the polyphenylene sulfide film with which the degree of the "heat damage" is reduced.

That is, the present invention provides a biaxially oriented polyphenylene sulfide film which has an elongation in the longitudinal direction of not more than 0.4% when the film is heated from 25 - 70 °C at a rate of 10 °C/min. under a tension of 3 kg per $1mm^2$ of the cross sectional area of the film.

The present invention further provides a process of manufacturing the above-described biaxially oriented polyphenylene sulfide film of the present invention, comprising the steps of melt-extruding a resin composition containing polyphenylene sulfide as a major composition to produce a non-oriented sheet; stretching the non-oriented sheet in the longitudinal and lateral directions simultaneously or sequentially to produce a biaxially oriented film; heat-treating the biaxially-oriented film at a temperature not lower than 200 °C and lower than the melting point of the film to obtain an intermediate; and additionally heat-treating the intermediate at a temperature of 30 - 120 °C for 1 second to 10 days.

The present invention still further provides a method of vacuum vapor-depositing a metal on at least one surface of a polyphenylene sulfide film by using a spooling type vacuum vapor-deposition apparatus, characterized in that the polyphenylene sulfide film is the polyphenylene sulfide film of the present invention and that the vapor-deposition is carried out under an average longitudinal tension of 0.5 - 3 kg per 1 $mm^2$ of the cross sectional area of the film on the cooling can.

The polyphenylene sulfide film of the present invention is unlikely to be wrinkled on the cooling can of a vapor-deposition apparatus when the film is metallized by using a spooling type vacuum vapor-deposition apparatus and so the "heat damage" hardly occurs. By the process of the present invention, the polyphenylene sulfide film of the present invention may be manufactured with high efficiency. Further, by the method of vacuum vapor-deposition of the present invention, the degree of the "heat damage" is

certainly reduced. As a result, a metallized film with excellent flatness and dimensional precision which are advantageous for producing a metallized film capacitor may be obtained with high production efficiency, and the capacitor made from the resulting metallized film has a stable characteristics.

BEST MODE FOR CARRYING OUT THE INVENTION

In the present invention, the polyphenylene sulfide film (hereinafter also referred to as "PPS film" for short) means a biaxially oriented film made of a resin composition containing poly-p-phenylene sulfide as a major component.

The resin composition containing the poly-p-phenylene sulfide as a major component (hereinafter also referred to as "PPS-based composition") herein means a composition containing poly-p-phenylene sulfide in the amount of not less than 70% by weight. If the content of the poly-p-phenylene sulfide is less than 70% by weight, the crystallinity, thermal transition point and the like of the composition are lowered, so that the heat resistance, dimensional stability, mechanical properties and the like which are the advantageous features of the polyphenylene sulfide film are degraded. The remaining content of less than 30% by weight may be a polymer other than the poly-p-phenylene sulfide and/or an additive such as inorganic or organic fillers, lubricants, coloring agents, UV absorbers and the like. In view of the moldability, the melt viscosity of the resin composition may preferably be 500 - 12,000 poise, more preferably 700 - 10,000 poise at a temperature of 300°C under a shearing velocity of 200 l/sec. The melt viscosity of the resin composition is identical to the melt viscosity of the polyphenylene sulfide film finally obtained.

In the present invention, the poly-p-phenylene sulfide (hereinafter also referred to as "PPS" for short) means a polymer having a repeating unit represented by the formula

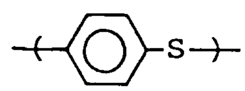

in the amount of 70 mol% (preferably 85 mol%). If this component is less than 70 mol%, the crystallinity, thermal transition point and the like of the polymer are lowered, so that the heat resistance, dimensional stability, mechanical properties and the like which are the advantageous features of the polyphenylene sulfide film are degraded.

The polyphenylene sulfide may contain other copolymerizable repeating unit having sulfide bond as long as the content thereof is less than 30 mol%, preferably less than 15 mol%.

The film of the present invention has an elongation in the longitudinal direction of not more than 0.4%, preferably not more than 0.3%, when the film is heated from 25°C to 70°C at a rate of 10°C/min. under a tension of 3 kg per 1 $mm^2$ of the cross sectional area of the film. If the above-mentioned elongation is more than 0.4%, the heat damage is likely to occur when the film is subjected to vacuum vapor-deposition, so that the object of the present invention cannot be attained. It is preferred that the elongation of the film in the same conditions as described above except that the heating is continued up to 80°C be not more than 0.4%.

Although the thickness of the film is not limited, in view of preventing the heat damage during the vacuum vapor deposition, it may preferably be 0.4 - 10 $\mu$m, more preferably 0.4 - 4 $\mu$m.

Although the surface characteristics of the film of the present invention may appropriately be selected depending on the demanded properties, the average surface roughness Ra of the film may preferably be 0.03 - 0.10 $\mu$m in view of the ease of handling in the winding step in the capacitor making process and of the intimacy with a heat press when the film is heat-pressed after winding. Further, in view of the quality of the vapor-deposition, the friction coefficient $\mu_k$ between the film and a metal surface, which is measured as described below may preferably be 0.1 - 0.8. If desired, for the purpose of adjusting the surface roughness, inorganic particles may be incorporated in the film of the present invention.

In view of the heat resistance, the film of the present invention may preferably be a crystallized film having a crystallinity measured by X-ray diffraction of 25 - 45%. Further, the degree of orientation OF of the film measured for the crystal peak of $2\theta$ = 20 - 21° may preferably be 0.07 - 0.5 in the end and edge directions and may preferably be 0.6 - 1.0 in the through direction.

The polyphenylene sulfide film of the present invention may be manufactured by, for example, the method which will now be described. That is, firstly, a resin composition containing the polyphenylene sulfide as a major component is melt extruded to produce a non-oriented sheet. This may be attained by a well-known conventional method by, for example, supplying the above-described resin composition to an extruder, melting the composition therein and extruding the melted composition from a T-die onto a cooling

drum, as disclosed in, for example, Japanese Laid Open Patent Application (Kokai) No. 111235/80.

The non-oriented sheet is then stretched in the longitudinal and lateral directions. The stretching may be carried out either by simultaneously or sequentially, by a well-known conventional method. Although not limited, the stretching temperature may usually be 95 - 115 °C and the stretching ratio may usually be 3 to 7 times the original length.

Then the resulting biaxially oriented film is heat-treated at a temperature not lower than 200 °C and lower than the melting point of the film to obtain an intermediate.

Then the resulting intermediate is heat-treated at a temperature of 30 - 120 °C for 1 second to 10 days additionally, preferably at a temperature of 40 - 120 °C for 1 minute to 10 days. The duration of this heat treatment may appropriately be selected depending on the temperature. In general, when the heat-treatment is carried out at a lower temperature, the heat-treatment is continued for a longer time, and when the heat-treatment is carried out at a higher temperature, the heat-treatment is continued for a shorter time. This heat treatment may be carried out sequentially with the production of the intermediate in the film-producing line, or may be carried out after the film is spooled. In the latter case, the heat treatment may be carried out continuously while unwinding the film or may be carried out by placing a roll of the film in an oven. The additional heat treatment may be conducted in two or more steps under different temperatures.

The method of vacuum vapor-deposition of the present invention will now be described. In the method of the vacuum vapor-deposition of the present invention, a metal is vapor-deposited on at least one surface of the above-described polyphenylene sulfide film of the present invention by using a spooling type vacuum vapor-deposition apparatus. The spooling type vacuum vapor-deposition apparatus is widely used in the art, and the metal is vapor-deposited on the surface of the film while making the film contact a cooling can disposed between a winding roll and a unwinding roll. The cooling can is cooled by circulating a coolant therein. In a preferred mode, the film is continuously wound about the winding roll.

In the method of vacuum vapor-deposition of the present invention, the average longitudinal tension of the film on the cooling can is set to 0.5 - 3 kg per 1 $mm^2$ of the cross sectional area of the film. If the tension is greater or smaller than this range, the heat damage is likely to occur. The average longitudinal tension of the film on the cooling can herein means the mathematical average of the tension in the longitudinal direction of the film just before the film is made to contact with the cooling can and the tension in the longitudinal direction of the film immediately after the film departs from the cooling can. In cases where a vacuum vapor-deposition apparatus with two cooling cans for continuously metallizing both surfaces of the film is employed, it is required that the above-described conditions be satisfied for each cooling can.

In view of reducing the degree of the heat damage, the coolant circulating in the cooling can may preferably have a temperature not higher than -15 °C.

The rate of vapor-deposition of the metal may preferably be not less than 50 m/min. in terms of the rate of the winding of the film in view of reducing the degree of the heat damage.

The metal to be vacuum vapor-deposited is not restricted, and the examples of the metal include aluminum, zinc, tin, copper, gold and silver. The method of heating the metal to be vacuum vapor-deposited is also not restricted and may be, for example, a resistance heating method or an electron beam heating method.

Although the thickness of the vapor-deposited metal layer may appropriately be selected depending on the characteristics demanded, the advantageous effect of the present invention is maximized when the thickness of the vapor-deposited metal layer is 20 - 200 nm.

The methods of measuring the characteristics concerning the present invention and the methods of evaluation of the effects will now be described.

(1) Elongation $S_{70}$ (or $S_{80}$)

The elongation in the longitudinal direction when the film is heated from 25 °C to 70 °C (or 80 °C) under a tension of 3 kg per 1 $mm^2$ of the cross sectional area of the film is measured as follows:
A sample strip with a longitudinal length of 1100 mm and a width of 10 mm is cut out from the film and a pair of marker lines are drawn near the edges of the sample strip with an interval $L_0$ of about 1000 mm. The sample strip is hung in a hot air oven after attaching a load corresponding to 3 kg per 1 $mm^2$ of the cross sectional area of the film to the lower edge of the sample strip, and the interval between the marker lines is measured with two line sensors. The temperature in the hot air oven is then elevated at a rate of 10 °C/min up to 70 °C (or 80 °C) and the interval L between the marker lines is measured at the instance that the temperature in the oven reaches 70 °C (or 80 °C). The $S_{70}$ (or $S_{80}$) is defined as 100 x $(L - L_0)/L_0$ (%).

(2) Degree of Heat Damage During Vapor-deposition

The metallized film obtained by the vapor-deposition is observed and the degree of the heat damage is evaluated according to the following criteria:
○: Although not more than ten-odd wrinkles running in the longitudinal direction are observed, the flatness of other region is good.
△: Not less than ten-odd wrinkles running in the longitudinal direction are observed and, in addition, the overall film is undulated. However, the wrinkles are extinguished during the film is tensed.
X : Not less than ten-odd wrinkles running in the longitudinal direction are observed and, in addition, the overall film is undulated. The wrinkles remain even when the film is tensed.

(3) Average Surface Roughness of Film

The average surface roughness of the film is measured in accordance with JIS-R0601.

(4) Friction Coefficient $\mu_k$ Between Film and Metal Surface

The film is made to run in a tape running tester TBT-300 (commercially available from Yokohama System Kenkyusho Inc.) at 25 °C, 50% RH. The friction coefficient $\mu_k$ between the film and the metal surface is determined by the following equation:

$$\mu_k = 0.733 \log(T_1/T_0)$$

wherein $T_0$ represents the tension of the film at the entrance side and $T_1$ represents the tension of the film at the exit side. The material of the guide is sus27 (surface roughness 0.2S), the film-winding angle is 180 °, and the running speed is 3.3 m/sec.

The present invention will now be described in more detail by way of examples thereof. It should be noted that the present invention is not limited to the examples hereinbelow described.

Example 1

(1) Production of Biaxially Oriented PPS Film of the Invention

In an autoclave, 23.6 kg (250 moles, containing 40% by weight of crystal water) of sodium sulfide, 100 g of sodium hydroxide, 36.1 kg of sodium benzoate and 79.2 kg of N-methyl-2-pyrrolidone (hereinafter also referred to as "NMP") were fed and the mixture was dehydrated at 205 °C. To the resulting mixture, 37.5 kg (255 moles) of 1,4-dichlorobenzene (hereinafter also referred to as "p-DCB) and 20.0 kg of NMP were added and the resultant was allowed to react at 265 °C for 4 hours. The reaction product was washed with water and dried to obtain 21.1 kg (yield 78%) of poly-p-phenylene sulfide containing 100 mol% of p-phenylene sulfide, which had a melt viscosity of 3100 poise.

To this composition, 0.1% by weight of silica fine particles with an average particle size of 0.7 µm and 0.05% by weight of calcium stearate were added and the resulting composition was melted at 310 °C in an extruder with 40 mm diameter. The melted composition was extruded from a T-die with a length of 400 mm and a clearance of 1.5 mm after filtration through a filter made of a metal fibers which has a 95% cut pore size of 10 µm, and the extruded composition was cast onto a metal drum of which surface is kept at 25 °C to solidify the composition to obtain a non-oriented film with a thickness of about 20 µm.

The thus obtained film was stretched in the longitudinal direction with a longitudinal stretching machine comprising rolls at a film temperature of 100 °C at a stretching ratio of 3.6 times the original length at a stretching rate of 30,000%/min. Then the film was stretched in the lateral direction in a tenter at 100 °C at a stretching ratio of 3.5 times the original length and at a stretching rate of 1000%/min, and the film was then heat-treated in a heat treatment chamber next to the same tenter at 270 °C for 10 seconds to obtain an intermediate (intermediate-1) with a thickness of 2 µm.

The resulting intermediate was wound in the form of a roll, and the resulting roll was heat-treated in an oven at a temperature of 100 °C for 24 hours to obtain the film of the present invention (film-1). The results of the evaluation of this film are shown in Table 1. Aluminum was vapor-deposited on a film sample with a width of 500 mm with a continuous spooling type one-side vapor-deposition apparatus commercially available from Nippon Shinku Giken Co., Ltd. The vapor-deposition was conducted under a tension of the film before and after the cooling can of 3 $kg/mm^2$ and the coolant circulating in the cooling can had a

temperature of -30 °C. The vapor-deposition was carried out such that vapor-deposited regions with a width of 9 mm and non-vapor-deposited regions with a width of 1 mm are alternately formed so as to form stripes. From Table 1, it can be seen that the degree of the heat damage is great in the intermediate (the intermediate corresponds to the conventional polyphenylene sulfide films), while the degree of the heat damage is small in the film of the present invention.

Example 2

The intermediate-1 obtained in Example 1 was wound into a roll and heat-treated as in Example 1 except that the temperature and the duration of the heat-treatment were varied, to obtain 5 films (film-2 to film-6) which had varied longitudinal elongation $S_{70}$ when the film is heated from 25 °C to 70 °C at a rate of 10 °C/min under a tension of 3 kg per 1 $mm^2$ of the cross sectional area of the film. These films were evaluated by the same methods as in Example 1 and the results are shown in Table 1. From Table 1, it can be seen that the degree of the heat damage is reduced when the elongation defined in the present invention is not more than 0.4%.

Example 3

On a sample with a width of 500 mm cut from the film-1 obtained in Example 1, aluminum was vapor-deposited with a continuous spooling type one-side vapor-deposition apparatus commercially available from Nippon Shinku Giken Co., Ltd. The temperature of the coolant circulating in the vapor-deposition apparatus was -30 °C and the vapor-deposition was carried out such that vapor-deposited regions with a width of 9 mm and non-vapor-deposited regions with a width of 1 mm are alternately formed so as to form stripes. In the vapor-deposition, the tension of the film on the cooling can was varied as shown in Table 2 to produce the films under 5 different conditions to obtain 5 metallized PPS films. From Table 2, it can be seen that the heat damage is drastically reduced if the film of the present invention is subjected to vapor-deposition under the conditions defined in the present invention.

Example 4

The intermediate-1 obtained in Example 1 was wound into a roll and heat-treated as in Example 1 except that the temperature and the duration of the heat-treatment were varied, to obtain 5 films (film-7 to film-11) which had varied longitudinal elongation $S_{70}$ when the film is heated from 25 °C to 70 °C at a rate of 10 °C/min under a tension of 3 kg per 1 $mm^2$ of the cross sectional area of the film. These films were subjected to vapor-deposition with aluminum as in Example 1 under varied average tension of the film on the cooling can shown in Table 3. The results of the evaluation are shown in Table 3. From Table 3, it can be seen that the degree of the heat damage is reduced if the film is metallized by the method of vapor-deposition according to the present invention.

Table 1

| Identification of Film | Elongation $S_{70}$ (%) | Heat Damage | Note |
|---|---|---|---|
| Intermediate-1 | 0.61 | X | Comparative Example |
| Film-1 | 0.22 | ○ | Example |
| Film-2 | 0.55 | X | Comparative Example |
| Film-3 | 0.45 | X | Comparative Example |
| Film-4 | 0.35 | △ | Example |
| Film-5 | 0.27 | ○ | Example |
| Film-6 | 0.19 | ○ | Example |

Table 2

| Condition | Film Used | Average Tension of Cooling Drum ($kg/mm^2$) | Heat Damage | Note |
|---|---|---|---|---|
| A | Film-1 | 0.3 | X | Comparative Example |
| B | ditto | 0.7 | ○ | Example |
| C | ditto | 1.5 | ○ | Example |
| D | ditto | 2.5 | ○ | Example |
| E | ditto | 3.5 | X | Comparative Example |

Table 3

| Condition | Film Used | Elongation $S_{70}$ (%) | Average Tension of Cooling Drum ($kg/mm^2$) | Heat Damage | Note |
|---|---|---|---|---|---|
| F | Film-7 | 0.13 | 2.5 | ○ | Example |
| G | Film-8 | 0.26 | 2.5 | ○ | Example |
| H | Film-9 | 0.35 | 2.5 | △ | Example |
| I | Film-10 | 0.36 | 4.0 | X | Comparative Example |
| J | Film-11 | 0.46 | 2.5 | X | Comparative Example |

## Claims

1. A biaxially oriented polyphenylene sulfide film which has an elongation ($S_{70}$) in the longitudinal direction of not more than 0.4% when the film is heated from 25 - 70 °C at a rate of 10 °C/min. under a

tension of 3 kg per 1mm$^2$ of the cross sectional area of the film.

2. The polyphenylene sulfide film of claim 1, wherein the longitudinal elongation ($S_{70}$) is not more than 0.3%.

3. The polyphenylene sulfide film of claim 1, which has an elongation ($S_{80}$) in the longitudinal direction of not more than 0.4% when the film is heated from 25 - 80 °C at a rate of 10 °C/min. under a tension of 3 kg per 1mm$^2$ of the cross sectional area of the film.

4. The film of claim 1, which has a thickness of 0.4 to 4 µm.

5. A process of manufacturing the biaxially oriented polyphenylene sulfide film of claim 1, comprising the steps of:
melt-extruding a resin composition containing polyphenylene sulfide as a major composition to produce a non-oriented sheet;
stretching the non-oriented sheet in the longitudinal and lateral directions simultaneously or sequentially to produce a biaxially oriented film;
heat-treating the biaxially-oriented film at a temperature not lower than 200 °C and not higher than the melting point of the film to obtain an intermediate; and
additionally heat-treating the intermediate at a temperature of 30 - 120 °C for 1 second to 10 days.

6. The process of claim 5, wherein the heat-treatment of the intermediate is conducted at a temperature of 40 - 120 °C for 1 minute to 10 days.

7. A method of vacuum vapor-depositing a metal on at least one surface of a polyphenylene sulfide film by using a spooling type vacuum vapor-deposition apparatus, characterized in that the polyphenylene sulfide film is the polyphenylene sulfide film of any one of claims 1 - 4 and that the vapor-deposition is carried out under an average longitudinal tension of 0.5 - 3 kg/mm$^2$ on the cooling can.

8. The method of claim 7, wherein the temperature of a coolant circulating in the cooling can is not higher than -15 °C.

9. The method of claim 7 or 8, wherein the rate of the vapor-deposition of the film is not less than 50 m/min. in terms of the winding speed of the film.

**Patentansprüche**

1. Biaxial orientierter Polyphenylensulfidfilm, der in Längsrichtung eine Dehnung ($S_{70}$) von nicht mehr als 0,4% aufweist, wenn der Film bei einer Rate von 10 °C/min unter einer Zugspannung von 3 kg pro 1 mm$^2$ der Querschnittsfläche des Films von -25 bis 70 °C erwärmt wird.

2. Polyphenylensulfidfilm nach Anspruch 1, worin die Längsdehnung ($S_{70}$) nicht mehr als 0,3% beträgt.

3. Polyphenylensulfidfilm nach Anspruch 1, der eine Dehnung ($S_{80}$) in Längsrichtung von nicht mehr als 0,4% aufweist, wenn der Film bei einer Rate von 10 °C/min unter einer Zugspannung von 3 kg pro 1 mm$^2$ der Querschnittsfläche des Films von 25 bis 80 °C erwärmt wird.

4. Film nach Anspruch 1, der eine Dicke von 0,4 bis 4 µm aufweist.

5. Verfahren der Herstellung des biaxial orientierten Polyphenylensulfidfilms nach Anspruch 1, das die Schritte umfaßt:
Schmelzextrudieren einer Harzzusammensetzung, welche Polyphenylensulfid als eine Hauptverbindung enthält, um eine nicht orientierte Bahn herzustellen;
Verstrecken der nicht orientierten Bahn in Längsrichtung und seitlicher Richtung gleichzeitig oder nacheinander, um einen biaxial orientierten Film herzustellen;
Wärmebehandeln des biaxial orientierten Films bei einer Temperatur von nicht weniger als 200 °C und nicht oberhalb des Schmelzpunktes des Films, um ein Zwischenprodukt zu erhalten; und
zusätzliche Wärmebehandlung des Zwischenproduktes bei einer Temperatur von 30 bis 120 °C für 1

Sekunde bis 10 Tage.

6. Verfahren nach Anspruch 5, worin die Wärmebehandlung des Zwischenproduktes bei einer Temperatur von 40 bis 120 °C für 1 Minute bis 10 Tage durchgeführt wird.

7. Verfahren der Vakuum-Dampfabscheidung eines Metalls auf wenigstens einer Oberfläche des Polyphenylensulfidfilms mittels einer Vorrichtung zur Vakuum-Dampfabscheidungvom Spulentyp, dadurch gekennzeichnet, daß der Polyphenylensulfidfilm der Polyphenylensulfidfilm nach einem der Ansprüche 1 bis 4 ist und die Dampfabscheidung auf der Kühlkann bei einer mittleren Längszuspannung von 0,5 bis 3 kg/mm$^2$ vorgenommen wird.

8. Verfahren nach Anspruch 7, worin die Temperatur eines in der Kühlkanne zirkulierenden Kühlmittels nicht mehr als -15 °C beträgt.

9. Verfahren nach Anspruch 7 oder 8, worin die Rate der Dampfabscheidung des Films nicht weniger als 50 m/min ausgedrückt in Form der Spulgeschwindigkeit des Films beträgt.

**Revendications**

1. Pellicule de sulfure de polyphénylène orientée biaxialement, qui présente un allongement ($S_{70}$) dans la direction longitudinale non supérieur à 0,4 % lorsque la pellicule est chauffée de 25 à 70 °C à une cadence de 10 °C/mn, sous une tension de 3 kg par mm$^2$ de la surface en coupe transversale de la pellicule.

2. Pellicule de sulfure de polyphénylène selon la revendication 1, dans laquelle l'allongement longitudinal ($S_{70}$) n'est pas supérieur à 0,3 %.

3. Pellicule de sulfure de polyphénylène selon la revendication 1, qui présente un allongement ($S_{80}$) dans la direction longitudinale non supérieur à 0,4 % lorsque la pellicule est chauffée de 25 à 70 °C à une cadence de 10 °C/mn, sous une tension de 3 kg par mm$^2$ de la surface en coupe transversale de la pellicule.

4. Pellicule selon la revendication 1, qui a une épaisseur de 0,4 à 4 µm.

5. Procédé de fabrication de la pellicule de sulfure de polyphénylène orientée biaxialement selon la revendication 1, comprenant les étapes consistant à :
   - extruder en masse fondue une composition de résine contenant du sulfure de polyphénylène comme composition principale pour produire une feuille non orientée;
   - étendre la feuille non orientée dans les directions longitudinale et latérale simultanément ou séquentiellement afin de produire une pellicule orientée biaxialement;
   - traiter thermiquement la pellicule orientée biaxialement à une température non inférieure à 200 °C et non supérieure au point de fusion de la pellicule de manière à obtenir un produit intermédiaire; et
   - traiter en plus thermiquement le produit intermédiaire à une température de 30 - 120 °C pendant 1 seconde à 10 jours.

6. Procédé selon la revendication 5, dans lequel le traitement thermique du produit intermédiaire est effectué à une température de 40 - 120 °C pendant 1 minute à 10 jours.

7. Procédé de déposition en phase vapeur sous vide d'un métal sur au moins une surface d'une pellicule de sulfure de polyphénylène en utilisant un appareil de déposition en phase vapeur sous vide du type à bobinage, caractérisé en ce que la pellicule de sulfure de polyphénylène est la pellicule de sulfure de polyphénylène de l'une quelconque des revendications 1 - 4, et en ce que la déposition en phase vapeur est exécutée à une tension longitudinale moyenne de 0,5 - 3 kg/mm$^2$ sur le pot de refroidissement.

8. Procédé selon la revendication 7, dans lequel la température d'un réfrigérant circulant dans le pot de refroidissement n'est pas supérieure à -15 °C.

9. Procédé selon la revendication 7 ou 8, dans lequel la cadence de la déposition en phase vapeur de la pellicule n'est pas inférieure à 50 m/mn en termes de vitesse de bobinage de la pellicule.